# EUROPEAN PATENT APPLICATION

(11) **EP 4 418 481 A2**
(43) Date of publication of application: **21.08.2024**
(21) Application number: 23208023.4
(22) Date of filing: 06.11.2023
(51) Int. Cl.: H02H 1/06, H02H 3/087, H02H 7/18, H02J 7/00

(54) **CHARGER IC INCLUDING SHORT PROTECTION CIRCUIT AND GROUND SHORT TEST METHOD THEREOF**

(30) Priority: 16.02.2023 KR 20230020733
(71) Applicant: Samsung Electronics Co., Ltd., Suwon-si, Gyeonggi-do 16677 (KR)
(72) Inventor: CHUNG, Youngwoo, Suwon-si 16677 (KR); HAN, Daeyong, Suwon-si 16677 (KR)
(74) Representative: Marks & Clerk LLP

(57) **Abstract**

A charger integrated circuit (1000) includes a plurality of power transistors (M1, M2, M3) configured to transmit one of a battery voltage (VBAT), a charging voltage (CHLVL), and a load voltage (VSYS) as an internal power supply voltage (VDDX) based on a voltage selection control signal, a voltage selector (1210) configured to, determine a highest voltage among a battery voltage, a charging voltage, and a load voltage, and transmit the voltage selection control signal to the plurality of power transistors (M1, M2, M3) based on results of the determination, a short current limiter (1240) configured to output the internal power supply voltage as a chip voltage (AVDD), and limit a level of a short circuit current corresponding to the chip voltage in response to a current control signal (CTRL_SCL), and a power drop sensor (1220) configured to generate the current control signal in response to a voltage level of the internal power supply voltage (VDDX) being lower than a voltage level of a reference voltage.

## Description

### TECHNICAL FIELD

Various example embodiments of the inventive concepts described herein relates to a semiconductor device, and more particularly, to a charger integrated circuit including a short circuit protection circuit for limiting short circuit current, a system including the charger integrated circuit, and/or a ground short circuit test method thereof, etc.

### BACKGROUND

Recently, various types of mobile devices for communication and/or information exchange have been released. A mobile device uses a rechargeable battery as a power source in order to enable mobility of the mobile device. In general, when a mobile device is connected to a charger (e.g., travel adapter, power adapter, etc.) which enables battery charging, it operates in a charging mode (or buck mode) for battery charging. To this end, the mobile device is equipped with a charger integrated circuit (IC) chip (e.g., battery charging IC circuitry, etc.) for charging the battery.

Through various tests, stability during various events that may occur within the charging integrated circuit during battery charging may be checked and/or tested. In particular, in the case of a ground short test on an output terminal (e.g., AVDD or PVDD) of the charger IC, power transistors and/or power rails of the charger IC may be damaged due to generated overcurrent caused by a short circuit event. Therefore, there is a demand for a technology capable of protecting elements and/or components included in the charger from the short circuit current even when the ground short test is applied.

### SUMMARY

Various example embodiments of the inventive concepts provide a charger integrated circuit capable of protecting internal elements and/or components during a ground short test, a system including the charger integrated circuit, and/or a ground short test method thereof.

According to at least one example embodiment, a charger integrated circuit comprising, a plurality of power transistors configured to, receive a battery voltage, a charging voltage, and a load voltage, respectively, and transmit one of the battery voltage, the charging voltage, and the load voltage to a first power node as an internal power supply voltage based on a voltage selection control signal; a voltage selector configured to, determine a highest voltage among a battery voltage, a charging voltage, and a load voltage, and transmit the voltage selection control signal to the plurality of power transistors based on results of the determination; a short current limiter configured to, output the internal power supply voltage as a chip voltage, and limit a level of a short circuit current corresponding to the chip voltage flowing to ground in response to a current control signal, and a power drop sensor configured to generate the current control signal in response to a voltage level of the chip voltage being lower than a voltage level of a reference voltage.

According to at least one example embodiment, a charger integrated circuit, comprising, a first power transistor configured to switch a power supply voltage to a first power node, a second power transistor configured to switch the power supply voltage to a second power node to provide a first chip voltage, a power drop sensor configured to activate a current control signal in response to a voltage level of the first chip voltage being lower than voltage level of a reference voltage, and a gate control circuit configured to switch the second power transistor from a turned-on mode to a saturation mode in response to activation of the current control signal, the saturation mode causing a current of the first chip voltage to be limited to a desired current level.

The desired current level may be a saturation current of the second power transistor.

According to at least one example embodiment, a ground short test method of a charger integrated circuit, the method including transferring a selected power supply voltage to a first power node through a power transistor, comparing a voltage level of a chip voltage with a voltage level of a reference voltage, the chip voltage being output from a second power node, and operating a short circuit protection transistor to limit a current of the chip voltage in response to the voltage level of the chip voltage being lower than the voltage level of the reference voltage, the short circuit protection circuit connected to the first power node and the second power node.

At least some of the above and other features of the invention are set out in the claims.

### BRIEF DESCRIPTION OF THE FIGURES

The above and other objects and features of one or more example embodiments of the inventive concepts will become apparent by describing in detail various example embodiments thereof with reference to the accompanying drawings.
FIG. 1 is a block diagram showing a mobile device including a charger integrated circuit according to at least one example embodiment of the inventive concepts.
FIG. 2 is a block diagram showing the configuration of the charger integrated circuit of at least one example embodiment of the inventive concepts.
FIG. 3 is a circuit diagram briefly showing the structure of the power selector of FIG. 2 according to some example embodiments.
FIG. 4 is a table briefly showing the function of the maximum voltage selector of FIG. 3 according to some example embodiments.
FIG. 5 is a circuit diagram showing an example configuration of the power drop sensor of FIG. 3 according to some example embodiments.
FIG. 6 is a timing diagram illustrating a process of generating a current control signal CTRL_SCL by a power drop sensor when a first chip voltage PVDD is short circuited to ground according to at least one example embodiment of the inventive concepts.
FIG. 7 is a timing diagram illustrating a process of generating a current control signal CTRL_SCL by a power drop sensor during a ground short test the second chip voltage AVDD according to at least one example embodiment of the inventive concepts.
FIG. 8 is a circuit diagram for explaining the short circuit current limiting operation of the short current limiter according to at least one example embodiment of the inventive concepts.
FIG. 9 is an example waveform diagram of a charger integrated circuit according to at least one example embodiment of the inventive concepts.
FIG. 10 is a graph showing a result of a ground short test for a first chip voltage PVDD of a charger integrated circuit according to at least one example embodiment of the inventive concepts.
FIG. 11 is a graph showing a result of a ground short test for the second chip voltage AVDD of the charger integrated circuit according to at least one example embodiment of the inventive concepts.
FIG. 12 is a block diagram showing a power system of a mobile device according to at least one example embodiment of the inventive concepts.

### DETAILED DESCRIPTION

It is to be understood that both the foregoing general description and the following detailed description are examples. Reference signs are indicated in detail in the example embodiments of the inventive concepts, examples of which are indicated in the reference drawings. Wherever appropriate, the same reference numbers are used in the description and drawings to refer to the same or like parts.

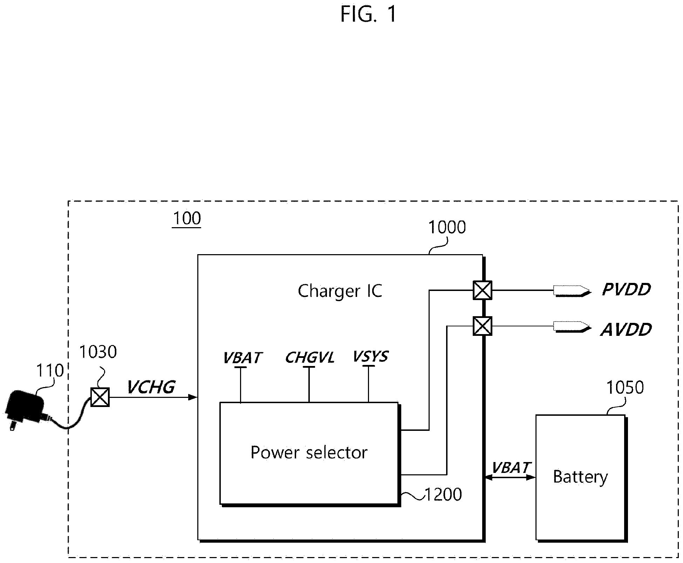

FIG. 1 is a block diagram showing a mobile device including a charger integrated circuit according to at least one example embodiment of the inventive concepts. Referring to FIG. 1, a mobile device 100 of at least one example embodiment of the inventive concepts may include a charger integrated circuit 1000 and/or a battery 1050, etc., but the example embodiments are not limited thereto, and for example, the mobile device may include a greater or lesser number of constituent components.

When the power adapter 110 (e.g., travel adapter, charging adapter, charging cable, power adapter, power cable, etc.) is connected to the charging terminal 1030 of the mobile device 100, the charger integrated circuit (IC) 1000 (e.g., charger circuitry, charging circuitry, etc.) may charge the battery 1050 using the input voltage VCHG provided through the power adapter 110. According to some example embodiments the input voltage VCHG may be an alternating current (AC) or a direct current (DC) voltage. For example, the charger IC 1000 operates in a buck mode for charging the battery 1050 by switching the input voltage VCHG provided through the power adapter 110, but the example embodiments are not limited thereto. The charger IC 1000 may charge the battery 1050 using the charging voltage CHGVL obtained by converting the input voltage VCHG and/or may provide the load voltage VSYS. According to at least one example embodiment, when the power adapter 110 is removed, the charger IC 1000 may output the load voltage VSYS to one or more internal components of the mobile device 100 using the battery voltage VBAT provided from the battery 1050, but the example embodiments are not limited thereto, and for example, the charger IC 1000 may output the load voltage VSYS while the power adapter 110 is connected to the charging terminal 1030 and/or the power adapter 110 is providing the input voltage VCHG to the charger IC 1000, etc.

The charger IC 1000 includes the power selector 1200 to perform the above-described voltage and/or power selection functions. The power selector 1200 selects the highest voltage among, e.g., the battery voltage VBAT, the charging voltage CHGVL, and/or the load voltage VSYS, but is not limited thereto. The power selector 1200 may provide the selected voltage as an external and/or internal power supply voltage. For example, the power selector 1200 provides the selected voltage as, for example, a first chip voltage PVDD for use as chip power of the charger IC 1000 and/or a second chip voltage AVDD for driving analog circuits, etc., but the example embodiments are not limited thereto, and for example, the selected voltage may be provided for a single chip voltage or three or more than chip voltages, etc.

In at least one specific test of the charger IC 1000, a ground short test is desired and/or required for the plurality of chip voltages, e.g., first chip voltage PVDD and/or the second chip voltage AVDD, etc. The ground short test is a test to verify the characteristics of short current generated when the first chip voltage PVDD output terminal and/or the second chip voltage AVDD output terminal is grounded, and/or to verify the protection capability of the charger integrated circuit 1000, but is not limited thereto.

The power selector 1200 of at least one example embodiment of the inventive concepts may limit a current level of a short circuit current (e.g., the current of the internal power supply voltage) generated during the ground short test for the first chip voltage PVDD output terminal and/or the second chip voltage AVDD output terminal, etc. Through the short circuit current limiting function, the power selector 1200 may protect internal elements and/or components of the mobile device 100 and/or the charger IC 1000 from impact and/or damage due to overcurrent from the internal power supply voltage. In addition, the power selector 1200 may continuously supply an internal power supply voltage (not shown, VDDX) capable of driving internal circuits even when the levels of the first chip voltage PVDD and the second chip voltage AVDD drop sharply. Therefore, even while the ground short test is performed for the first chip voltage PVDD and/or the second chip voltage AVDD, and/or a ground short occurs during operation of the mobile device 100 and/or the charger IC 1000, the charger IC 1000 may normally perform internal control functions and/or operations.

As described above, the charger integrated circuit 1000 of at least one example embodiment of the inventive concepts includes the power selector 1200 which is capable of limiting the overcurrent generated by the internal power supply voltage during the ground short test. During the ground short test, the power selector 1200 selects at least one voltage among the battery voltage VBAT, the charging voltage CHGVL, and the load voltage VSYS, etc., for example, the power selector 1200 may select a highest voltage among the battery voltage VBAT, the charging voltage CHGVL, and the load voltage VSYS, etc., but is not limited thereto, and supplies the selected voltage to the internal power supply voltage VDDX node. Further, the internal power supply voltage VDDX node may be separated from the chip voltage (e.g., PVDD, AVDD) nodes through a back-to-back diode-structured power switch (e.g., a short circuit protection transistor). The power selector 1200 may generate a current control signal for limiting the size and/or amount of the short circuit current by detecting the voltage drop of the chip voltage (e.g., PVDD, AVDD) nodes during the performance of the ground short test. The gate voltage of the power switch may be controlled using the current control signal generated by the power transistors to limit the amount of overcurrent generated by the internal power supply voltage during the ground short test a desired and/or certain level. The structure and function of the power selector 1200 for limiting the overcurrent of the internal power supply voltage will be described in detail through the drawings to be described later.

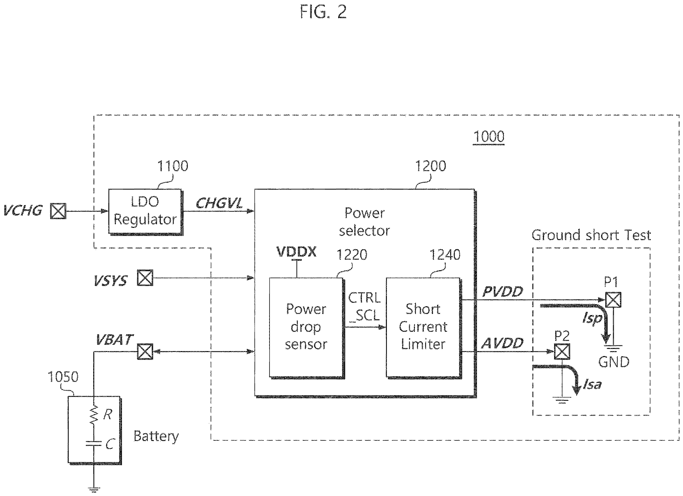

FIG. 2 is a block diagram showing the configuration of the charger integrated circuit of at least one example embodiments of the inventive concepts. Referring to FIG. 2, the charger IC 1000 may include a low-dropout (LDO) regulator 1100 and/or a power selector 1200, etc., but is not limited thereto. The power selector 1200 may include a power drop sensor 1220 and/or a short current limiter 1240, etc., but is not limited thereto.

The LDO regulator 1100 converts the input voltage VCHG provided from the power adapter 110 (see, e.g., FIG. 1) into a stable charging voltage CHGVL. The LDO regulator 1100 features and/or causes a low voltage drop between an input voltage VCHG and a charge voltage CHGVL corresponding to the output. Therefore, the LDO regulator 1100 is a linear regulator with little ripple of the charging voltage CHGVL. However, the LDO regulator 1100 according to at least one example embodiment is just one example of a converter for providing a stable level of charging voltage CHGVL, and various regulators and/or converters may be used to provide a charging voltage CHGVL according to other example embodiments.

The power selector 1200 selects a voltage (such as the highest voltage) among a plurality of potential chip voltages, e.g., the battery voltage VBAT, the charging voltage CHGVL, and/or the load voltage VSYS, etc., and provides it as chip voltages AVDD and/or PVDD, etc. The power selector 1200 may limit the size and/or amount of a short circuit current generated by the internal power supply voltage during a ground short test operation for the first chip voltage PVDD and/or the second chip voltage AVDD, etc. During the ground short test operation for the first chip voltage PVDD, a pad P1 of the test board to which the first chip voltage PVDD is transmitted may be connected to the ground GND, but the example embodiments are not limited thereto. Then, the level of the first chip voltage PVDD is lowered due to the short circuit with ground GND, and the first short circuit current Isp flows to the ground. In this case, the power selector 1200 may detect a drop in the level of the first chip voltage PVDD that occurs during the ground short test and may limit the size, magnitude, and/or amount of the first short circuit current Isp to a desired and/or predetermined level. The power selector 1200 may detect a drop in the level of the second chip voltage AVDD and limit the level of the second short circuit current Isa even during the ground short test operation for the second chip voltage AVDD.

The power selector 1200 includes a power drop sensor 1220 to monitor the voltage levels of the chip voltages PVDD and/or AVDD and detect a drop in the voltage level of the chip voltages PVDD and/or AVDD, etc. The power selector 1200 may include a short current limiter 1240 for limiting the size, magnitude, and/or amount of the first short circuit current Isp and/or the second short circuit current Isa using a detection result of the power drop sensor 1220, but the example embodiments are not limited thereto. According to some example embodiments, the power selector 1200 and/or the power drop sensor 1220, etc., may be implemented as processing circuitry. The processing circuitry may include hardware or hardware circuit including logic circuits; a hardware/software combination such as a processor executing software and/or firmware; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc., but is not limited thereto.

The power drop sensor 1220 may activate or deactivate the current limiting function of the short current limiter 1240 by detecting a level drop of the chip voltages PVDD and/or AVDD, etc., or in other words, the power drop sensor 1220 may control the short current limiter 1240 based on a detected voltage level drop of the monitored at least one of chip voltage PVDD and/or AVDD, etc. For example, when the power drop sensor 1220 detects and/or determines that the monitored level of the first chip voltage PVDD and/or the second chip voltage AVDD is greater than or equal to a desired reference voltage, the power drop sensor 1220 deactivates (e.g., turns off) the current limiting function of the short current limiter 1240. That is, the power drop sensor 1220 sets the power switch that switches the first chip voltage PVDD and/or the second chip voltage AVDD of the short current limiter 1240 to a fully turn-on mode (e.g., a normal operation mode, etc.). According to at least one example embodiment, the power drop sensor 1220 controls the short current limiter 1240 by generating and/or transmitting a current control signal CTRL_SCL to the short current limiter 1240 based on the detected level drop of the chip voltages PVDD and/or AVDD, etc.

On the other hand, the power drop sensor 1220 activates (e.g., turns on) the current limiting function of the short current limiter 1240 using the current control signal CTRL_SCL in response to the power drop sensor 1220 detecting and/or determining that the level of the first chip voltage PVDD and/or the second chip voltage AVDD is lower than the desired reference voltage. The power drop sensor 1220 is driven using an internal power supply voltage VDDX provided through a node separated from a node where the chip voltages AVDD and/or PVDD are formed. That is, the power drop sensor 1220 stably uses a separate internal power supply voltage VDDX from the chip voltages AVDD and/or PVDD even if the chip voltages AVDD and/or PVDD drop during the ground short test operation. Accordingly, the power drop sensor 1220 may stably generate the current control signal CTRL_SCL without being affected by level changes of chip voltages AVDD and PVDD, etc.

The short current limiter 1240 may limit the first short circuit current Isp and/or the second short circuit current Isa according to and/or based on the current control signal CTRL_SCL provided by the power drop sensor 1220. The short current limiter 1240 may transfer the internal power supply voltage VDDX to a first chip voltage node for providing the first chip voltage PVDD through a first short circuit protection transistor (not shown). In addition, the short current limiter 1240 transfers the internal power supply voltage VDDX to the second chip voltage node for providing the second chip voltage AVDD through a second short circuit protection transistor (not shown). The first and second short circuit protection transistors are driven in a turned-on state during the normal mode (e.g., a first mode, a first operation mode, etc.). However, when the current control signal CTRL_SCL is activated during the ground short test, the first and second short circuit protection transistors are driven in a saturation mode (e.g., a second mode, a second operation mode, a test mode, etc.). Therefore, during the ground short test, the magnitude, size, level, and/or amount of the first short circuit current Isp and/or the second short circuit current Isa flowing through the first short circuit protection transistor and/or the second short circuit protection transistor may be limited and/or decreased, thereby protecting the internal components of the mobile device 100 and/or the charger IC 1000 from damage from an overcurrent, etc.

The battery 1050 may be built into and/or connected to the mobile device 100, but the example embodiments are not limited thereto, and for example, the battery 1050 may be omitted and the mobile device 100 may be driven directly by the power adapter 110, etc. In at least one example embodiment, the battery 1050 may be detachable from the mobile device 100. The battery 1050 may include one or a plurality of battery cells. A plurality of battery cells may be connected in series and/or parallel.

As described above, the charger integrated circuit 1000 according to at least one example embodiment of the inventive concepts includes the power selector 1200 operable even when the chip voltage (e.g., AVDD and/or PVDD) drops during the ground short test. Accordingly, the charger integrated circuit 1000 may limit and/or decrease an overcurrent due to a short circuit during the ground short test operation and/or if a short circuit develops during a normal charging operation (e.g., a non-test operation) of the mobile device 100 using a power adapter 110, etc. The power selector 1200 may separate the internal power supply voltage (e.g., VDDX) node from the output voltage (e.g., PVDD, AVDD) nodes through a short circuit protection transistor having a back-to-back diode structure, but is not limited thereto. The power selector 1200 may detect the voltage drop of the chip voltage nodes PVDD and/or AVDD to generate the current control signal CTRL_SCL for limiting the size, level, amount, magnitude, and/or duration of the short circuit current. Since the gate voltage of the short circuit protection transistor is controlled by the current control signal CTRL_SCL, the power selector 1200 may limit the size, level, magnitude, amount, and/or duration of overcurrent generated during the ground short test and/or during normal operation of the mobile device 100, etc.

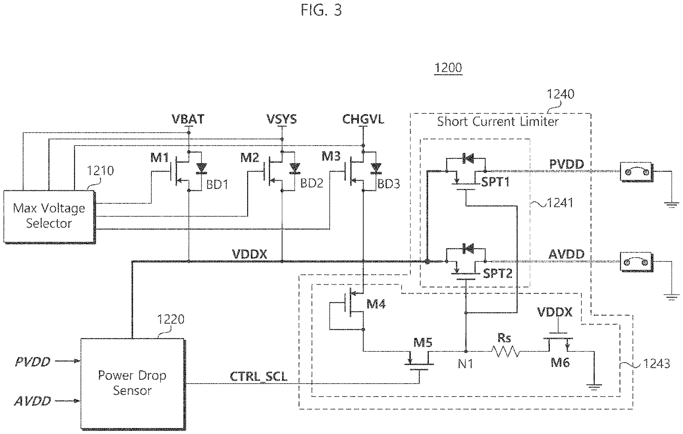

FIG. 3 is a circuit diagram briefly showing the structure of the power selector of FIG. 2 according to some example embodiments. Referring to FIG. 3, the power selector 1200 includes a plurality of power transistors, e.g., power transistors M1, M2, and M3, etc., a maximum voltage selector 1210 (e.g., a voltage detector, a chip voltage selector, etc.), a power drop sensor 1220, and/or a short current limiter 1240, etc., but the example embodiments are not limited thereto.

According to at least one example embodiment, the power transistors M1, M2, and M3 respectively switch the battery voltage VBAT, the charging voltage CHGVL, and/or the load voltage VSYS, etc., according to and/or based on the control of the maximum voltage selector 1210. The first power transistor M1 switches the battery voltage VBAT and transfers it to the internal power supply voltage VDDX node. The first power transistor M1 may be implemented as, for example, a PMOS transistor, but is not limited thereto. The source of the first power transistor M1 is connected to the battery voltage VBAT and the drain of the first power transistor M1 is connected to the internal power voltage VDDX node, but is not limited thereto. The first power transistor M1 may include a body diode BD1 corresponding to a parasitic diode of the PMOS transistor, but is not limited thereto. A leakage current that may occur when the first power transistor M1 is turned off may be blocked by the body diode BD1, etc.

According to at least one example embodiment, the second power transistor M2 switches the load voltage VSYS and transfers it to the internal power voltage VDDX node. The second power transistor M2 may also be implemented as a PMOS transistor, but is not limited thereto. The source of the second power transistor M2 is connected to the load voltage VSYS and the drain of the second power transistor M2 is connected to the internal power supply voltage VDDX node, but is not limited thereto. A body diode BD2 is also formed in the second power transistor M2, but is not limited thereto. A leakage current that may occur when the second power transistor M2 is turned off may be blocked by the body diode BD2, etc.

According to at least one example embodiment, the third power transistor M3 switches the charging voltage CHGVL and transfers it to the internal power supply voltage VDDX node. The third power transistor M3 may also be implemented as a PMOS transistor, but is not limited thereto. The source of the third power transistor M3 is connected to the charging voltage CHGVL and the drain of the third power transistor M3 is connected to the internal power supply voltage VDDX node, but is not limited thereto. The third power transistor M3 may also block leakage current that may occur in a turn-off state by the body diode BD3, etc.

It has been described that all of the power transistors M1, M2, and M3 are implemented as PMOS transistors, but the example embodiments of the inventive concepts are not limited thereto. For example, one or more of the power transistors M1, M2, and M3 may be implemented as an NMOS transistor, but the example embodiments are not limited thereto, and for example, the power transistors may be implemented as non-MOSFET transistors, etc. Additionally, each of the power transistors M1, M2, and M3 may be implemented in a form in which a plurality of PMOS transistors and/or NMOS transistors are cascaded, etc.

The maximum voltage selector 1210 compares the respective levels of the battery voltage VBAT, the charging voltage CHGVL, and the load voltage VSYS, and selects, for example, the voltage with the highest voltage level, but the example embodiments are not limited thereto, and for example, the maximum voltage selector 1210 may select a voltage above a desired threshold voltage level, etc., select each of the voltages in sequential order, select the voltages in random order, select the voltages on a periodic basis, select the voltage based on user input, etc. The maximum voltage selector 1210 controls the power transistors M1, M2, and M3 to transmit the highest-level voltage among the battery voltage VBAT, the charging voltage CHGVL, and the load voltage VSYS to the internal power supply voltage VDDX node, but the example embodiments are not limited thereto. For example, when the charging voltage CHGVL corresponds to the highest level, the maximum voltage selector 1210 turns off the first and second power transistors M1 and M2 and turns on the third power transistor M3, but the example embodiments are not limited thereto.

The power drop sensor 1220 monitors the levels of the chip voltages PVDD and/or AVDD and generates a current control signal CTRL_SCL according to and/or based on the monitoring result. In particular, the power drop sensor 1220 uses the internal power supply voltage VDDX as a power source to monitor the level drop of the chip voltages PVDD and/or AVDD. The power drop sensor 1220 generates a current control signal CTRL_SCL for activating the short circuit current limiting function of the short current limiter 1240 when at least one of the chip voltages PVDD and AVDD drops below the reference voltage VREF, but the example embodiments are not limited thereto. The power drop sensor 1220 is driven by using the internal power supply voltage VDDX provided as a node separate from the nodes for the chip voltages PVDD and AVDD during the ground short test, but is not limited thereto. Accordingly, even in a state where the chip voltages PVDD and/or AVDD rapidly decrease due to the ground short test, the power drop sensor 1220 may continue and/or maintain monitoring of the chip voltages PVDD and/or AVDD and provide overcurrent limiting functions, etc.

The short current limiter 1240 includes a plurality of short circuit protection transistors 1241, but is not limited thereto. According to at least one example embodiment, the plurality of short circuit protection transistors 1241 includes a first short circuit protection transistor SPT1 that provides the internal power supply voltage VDDX as the first chip voltage PVDD in a normal mode. In addition, the plurality of short circuit protection transistors 1241 include a second short circuit protection transistor SPT2 that provides the internal power supply voltage VDDX as the second chip voltage AVDD in a normal mode, but the example embodiments are not limited thereto. The first and second short circuit protection transistors SPT1 and SPT2 are controlled by the voltage formed at the first node N1, but are not limited thereto.

During normal operation, the levels of the first chip voltage PVDD and/or the second chip voltage AVDD are maintained above the reference voltage VREF. Consequently, the power drop sensor 1220 generates a high level 'H' current control signal CTRL_SCL. The high level 'H' current control signal CTRL_SCL turns off the transistor M5 of the short current limiter 1240. At this time, the transistor M6 maintains a turned-on state by the internal power supply voltage VDDX, and the voltage of the first node N1 maintains the ground voltage level. Then, the first and second short circuit protection transistors SPT1 and SPT2 maintain a turned-on state, and the internal power supply voltage VDDX is provided as the first chip voltage PVDD and/or the second chip voltage AVDD, but the example embodiments are not limited thereto.

On the other hand, during the ground short test operation and/or when a short circuit event occurs during normal operation, the output terminal of the first chip voltage PVDD and/or the second chip voltage AVDD is grounded. Accordingly, the level of the first chip voltage PVDD and/or the second chip voltage AVDD becomes lower than the reference voltage VREF. Then, the power drop sensor 1220 generates a low level 'L' current control signal CTRL_SCL based on detecting the voltage drop in the first chip voltage PVDD and/or the second chip voltage AVDD. Transistor M5 of the short current limiter 1240 is turned on as the low level 'L' current control signal CTRL_SCL is provided. Accordingly, a current path in which the internal power supply voltage VDDX is grounded via the diode-connected transistor M4 and M5, the resistor Rs, and the transistor M6 is formed, but the example embodiments are not limited thereto.

According to at least one example embodiment, Gate voltages of the first short circuit protection transistor SPT1 and/or the second short circuit protection transistor SPT2 are built up at the first node N1 by the resistor Rs present in the current path formed between the internal power supply voltage VDDX node and the ground node, but the example embodiments are not limited thereto. Therefore, during normal operation, the first short circuit protection transistor SPT1 and the second short circuit protection transistor SPT2 maintain a turned-on state. However, during the ground short test operation and/or during a short circuit event during normal operation, the first short circuit protection transistor SPT1 and/or the second short circuit protection transistor SPT2 is operated in the saturation mode by the gate voltage formed at the first node N1, but is not limited thereto. Accordingly, the level of the gate-source voltage Vgs of the first short circuit protection transistor SPT1 and/or the second short circuit protection transistor SPT2 may be controlled by selecting the size of the resistor Rs. The saturation current of the first short circuit protection transistor SPT1 and/or the second short circuit protection transistor SPT2 may be adjusted by adjusting the level of the gate-source voltage Vgs. Accordingly, the magnitude of the short circuit current flowing through the first short circuit protection transistor SPT1 and/or the second short circuit protection transistor SPT2 operating in the saturation mode may be controlled by the short current limiter 1240.

Here, the plurality of transistors M4, M5, and M6 and/or the resistor Rs forming a current path between the internal power supply voltage VDDX node and the ground node may be referred to as a gate control circuit 1243, but the example embodiments are not limited thereto. This is because the gate voltage of the first short circuit protection transistor SPT1 and/or the second short circuit protection transistor SPT2 may be controlled by the transistors M4, M5, and M6 and the resistor Rs, etc.

In the above, the method of limiting the short circuit current performed during the ground short test operation and/or during a short circuit event during normal operation of the power selector 1200 has been described. During the ground short test and/or during a short circuit event during normal operation, the first short circuit protection transistor SPT1 and/or the second short circuit protection transistor SPT2 of the short circuit current limiter 1240 operates in saturation mode by the current control signal CTRL_SCL generated by the power drop sensor 1220. The short circuit current flowing through these transistors may be limited to the saturation current level by the first short circuit protection transistor SPT1 and/or the second short circuit protection transistor SPT2 operating in the saturation mode, etc.

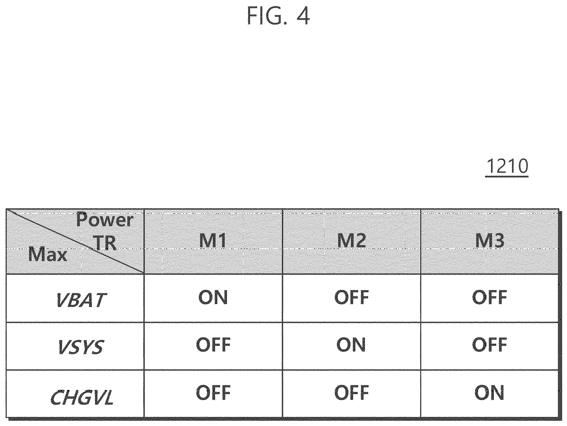

FIG. 4 is a table showing the function of the maximum voltage selector of FIG. 3 according to some example embodiments. Referring to FIG. 4, the maximum voltage selector 1210 selects the highest one among the battery voltage VBAT, the charging voltage CHGVL, and the load voltage VSYS, and provides it as the internal power supply voltage VDDX, but the example embodiments are not limited thereto.

The maximum voltage selector 1210 turns on the first power transistor M1 when it is determined that the battery voltage VBAT is the highest among the power supply voltages VBAT, VSYS, and CHGVL, but the example embodiments are not limited thereto. Further, the maximum voltage selector 1210 turns off the second and third power transistors M2 and M3 when it is determined that the battery voltage VBAT is the highest. Accordingly, the battery voltage VBAT is transferred to the internal power voltage VDDX node by the first power transistor M1.

On the other hand, when the load voltage VSYS is at the highest level, the maximum voltage selector 1210 turns off the first and third power transistors M1 and M3 and turns on the second power transistor M2. Then, the load voltage VSYS is transferred to the internal power voltage VDDX node by the second power transistor M2.

When the charging voltage CHGVL among the power supply voltages corresponds to the highest level, the maximum voltage selector 1210 turns off the first and second power transistors M1 and M2, and turns on the third power transistor M3. Then, the charging voltage CHGVL is transferred to the internal power voltage VDDX node by the third power transistor M3.

In the above, the function of the maximum voltage selector 1210 for providing the highest voltage among power supply voltages as the internal power supply voltage VDDX has been briefly described, but the example embodiments are not limited thereto. The highest voltage selection function of the maximum voltage selector 1210 described through the table may be implemented through various comparators, logic circuits, and/or processing circuitry, etc., but is not limited thereto.

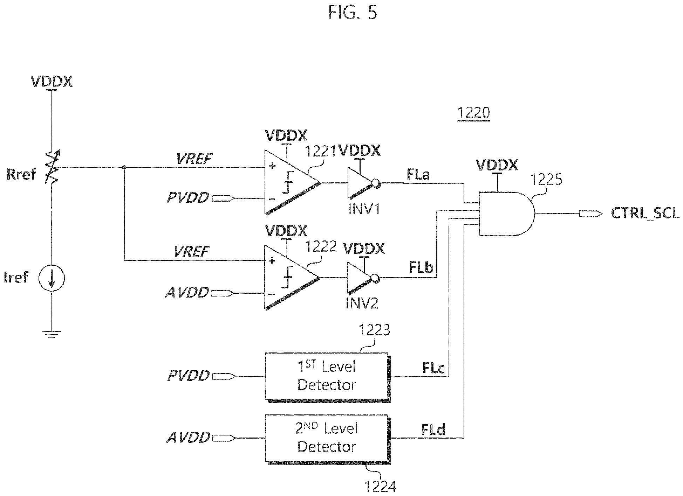

FIG. 5 is a circuit diagram showing an example configuration of the power drop sensor of FIG. 3 according to some example embodiments. Referring to FIG. 5, the power drop sensor 1220 includes a plurality of comparators, e.g., comparators 1221 and 1222, etc., that monitor chip voltages AVDD and/or PVDD and detect level changes of chip voltages AVDD and/or PVDD, a plurality of inverters, e.g., inverters INV1 and INV2, etc., and/or a plurality of level detectors, e.g., level detectors 1223, 1224, etc., and/or an AND gate 1225, but the example embodiments are not limited thereto. In particular, the power drop sensor 1220 is driven using an internal power supply voltage VDDX managed as a node separated from nodes of the chip voltages AVDD and PVDD which are grounded during a ground short test, etc.

A reference resistor Rref and a reference current source Iref are provided to generate the reference voltage VREF of the comparators 1221 and 1222 using the internal power supply voltage VDDX, but the example embodiments are not limited thereto. The internal power supply voltage VDDX is divided by the reference resistor Rref and the current source Iref to generate the reference voltage VREF. For example, if the internal power supply voltage VDDX is 4V, and when the comparators 1221 and 1222 are to be set to detect whether the chip voltages AVDD and PVDD drop below, e.g., 3.5V, the reference voltage VREF must be set to 3.5V, but the example embodiments are not limited thereto. Accordingly, the reference resistor Rref and reference current source Iref are adjusted to divide the internal supply voltage VDDX to provide a reference voltage VREF of, e.g., 3.5V, but are not limited thereto.

The first comparator 1221 monitors the level of the first chip voltage PVDD. When the voltage level of the first chip voltage PVDD is equal to or higher than the reference voltage VREF, the first comparator 1221 generates a low level 'L' output signal. Then, the first inverter INV1 inverts the low-level output signal of the first comparator 1221 to generate the high-level first flag signal FLa. On the other hand, when the voltage level of the first chip voltage PVDD is lower than the reference voltage VREF, the first comparator 1221 generates a high level 'H' output signal. Then, the first inverter INV1 inverts the high level output signal of the first comparator 1221 to generate the low level first flag signal Fla.

The second comparator 1222 monitors the level of the second chip voltage AVDD. When the voltage level of the second chip voltage AVDD is equal to or higher than the reference voltage VREF, the second comparator 1222 generates a low level 'L' output signal. Then, the second inverter INV2 inverts the low level output signal of the second comparator 1222 to generate the high level 'H' second flag signal FLb. On the other hand, when the voltage level of the second chip voltage AVDD is lower than the reference voltage VREF, the second comparator 1222 generates a high level 'H' output signal. Then, the second inverter INV2 inverts the high-level output signal of the second comparator 1222 to generate the low-level second flag signal FLb.

The first level detector 1223 monitors the level of the first chip voltage PVDD. The first level detector 1223 will generate the third flag signal FLc of low level 'L' when the level of the first chip voltage PVDD is lower than the desired and/or predetermined level threshold voltage Vth (e.g., Vth < VREF). Substantially, the first level detector 1223 can be used as an auxiliary means for controlling the level of the short circuit current when the first comparator 1221 and/or the first inverter INV1 do not operate normally due to a failure and/or error, but is not limited thereto.

The second level detector 1224 monitors the level of the second chip voltage AVDD. The second level detector 1224 will generate a fourth flag signal FLd of low level 'L' when the level of the second chip voltage AVDD is lower than the desired and/or predetermined level threshold voltage Vth (e.g., Vth < VREF). As a result, the second level detector 1224 serves as an auxiliary means for limiting the short circuit current when the second comparator 1222 and the second inverter INV2 do not operate normally.

The AND gate 1225 generates the current control signal CTRL_SCL by performing an logical AND operation on the first to fourth flag signals FLa, FLb, FLc, and FLd, but is not limited thereto. The AND gate 1225 provides a high-level 'H' current control signal CTRL_SCL when the first to fourth flag signals FLa, FLb, FLc, and FLd are all high-level 'H'. On the other hand, the AND gate 1225 generates a low-level 'L' current control signal CTRL_SCL when any one of the first to fourth flag signals FLa, FLb, FLc, and FLd is low level 'L'. Consequently, the AND gate 1225 maintains the high level 'H' current control signal CTRL_SCL when both of the voltage levels of the chip voltages AVDD and PVDD are equal to or greater than the reference voltage VREF. On the other hand, the AND gate 1225 transitions the current control signal CTRL_SCL to a low level 'L' to activate the current limit function when any one of the levels of the chip voltages AVDD and PVDD is lower than the reference voltage VREF.

Here, the first comparator 1221 and the first inverter INV1, the second comparator 1222 and the second inverter INV2, and the AND gate 1225 are driven using the internal power supply voltage VDDX as a power source. The level detectors 1223 and 1224 may also be driven using the internal power supply voltage VDDX. Accordingly, even when the levels of the chip voltages AVDD and PVDD drop rapidly during the ground short test, the power drop sensor 1220 continues to operate normally.

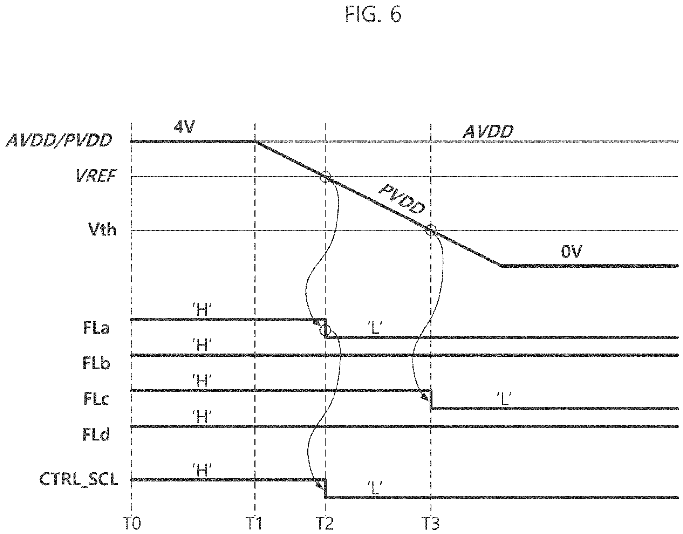

FIG. 6 is a timing diagram illustrating a process of generating a current control signal CTRL_SCL by a power drop sensor when a first chip voltage PVDD is short circuited to ground according to at least one example embodiment of the inventive concepts. Referring to FIGs. 5 and 6, an operation of the power drop sensor 1220 when the first chip voltage PVDD drops rapidly during a ground short test will be described, but the example embodiments are not limited thereto.

As shown in FIG. 6, at the time point T0, the operating state of the power drop sensor 1220 before the ground short test operation is performed is shown. That is, the chip voltages AVDD and PVDD maintain normal levels (e.g., 4V) higher than the reference voltage VREF, but the example embodiments are not limited thereto. Accordingly, the inverters INV1 and INV2 and the level detectors 1223 and 1224 all output flag signals FLa, FLb, FLc, and FLd of a high level 'H'. As a result, the AND gate 1225 will output the current control signal CTRL_SCL at a high level 'H'. In the high level 'H' state of the current control signal CTRL_SCL, the transistor M5 of the short current limiter 1240 is turned off, and the short circuit protection transistors SPT1 and SPT2 are fully turned on.

At time T 1, the ground short test operation for the first chip voltage PVDD starts. Then, the voltage level of the second chip voltage AVDD maintains a normal state, but the voltage level of the first chip voltage PVDD starts to fall. However, until the time T2, the voltage levels of both the first chip voltage PVDD and the second chip voltage AVDD are higher than the reference voltage VREF. Accordingly, all of the flag signals FLa, FLb, FLc, and FLd are maintained at a high level 'H'. Accordingly, the AND gate 1225 will output the current control signal CTRL_SCL at a high level 'H'.

At time T2, the voltage level of the first chip voltage PVDD becomes lower than the reference voltage VREF. Then, the first comparator 1221 will transition the comparison result from the low level 'L' to the high level 'H'. Then, the first inverter INV1 will transition the first flag signal FLa from the high level 'H' to the low level 'L'. As the first flag signal FLa among the four flag signals FLa, FLb, FLc, and FLd transitions to the low level 'L', the AND gate 1225 converts the current control signal CTRL_SCL to the low level 'L'. Then, the short current limiter 1240 activates the short circuit current limiting operation in response to the low level 'L' transition of the current control signal CTRL_SCL. When the current control signal CTRL_SCL becomes low level 'L', the transistor M5 of the short current limiter 1240 is turned on, and the short circuit protection transistors SPT1 and SPT2 are driven in the saturation mode. Therefore, the short circuit current flowing through the short circuit protection transistors SPT1 and SPT2 is limited and/or decreased to the saturation current level, etc.

At time T3, the voltage level of the first chip voltage PVDD becomes lower than the threshold voltage Vth (e.g., level threshold voltage, etc.). Then, the first level detector 1223 that monitors the level of the first chip voltage PVDD will transition the third flag signal FLc from the high level 'H' to the low level 'L'. As two flag signals FLa and FLc among the four flag signals FLa, FLb, FLc, and FLd transition to a low level 'L', the AND gate 1225 generates a low level 'L' current control signal CTRL_SCL. Accordingly, the short current limiter 1240 will continue to limit and/or decrease the short circuit current activated at the time point T2.

Generation of the current control signal CTRL_SCL through the third flag signal FLc makes it possible to compensate for an error of the first comparator 1221 at the time point T2. That is, even when the voltage levels of the first chip voltage PVDD and the reference voltage VREF are not normally compared due to a failure of the first comparator 1221 at time T2, the current control signal CTRL_SCL may transition normally by the first level detector 1223. The operation of the power drop sensor 1220 when the first chip voltage PVDD is grounded in the ground short test has been described above. The power drop sensor 1220 may activate the short circuit current limitation through the current control signal CTRL_SCL when any one of the voltage levels of the chip voltages AVDD and PVDD is lower than the reference voltage VREF. In addition, even when the first chip voltage PVDD drops below the normal level during the ground short test operation, the power drop sensor 1220 is driven by the internal power supply voltage VDDX managed as a node separate from the node of the first chip voltage PVDD. Therefore, monitoring of the chip voltages AVDD and PVDD of the power drop sensor 1220 and generation of the current control signal CTRL_SCL may be improved, increased and/or ensured even during the ground short test, but the example embodiments are not limited thereto.

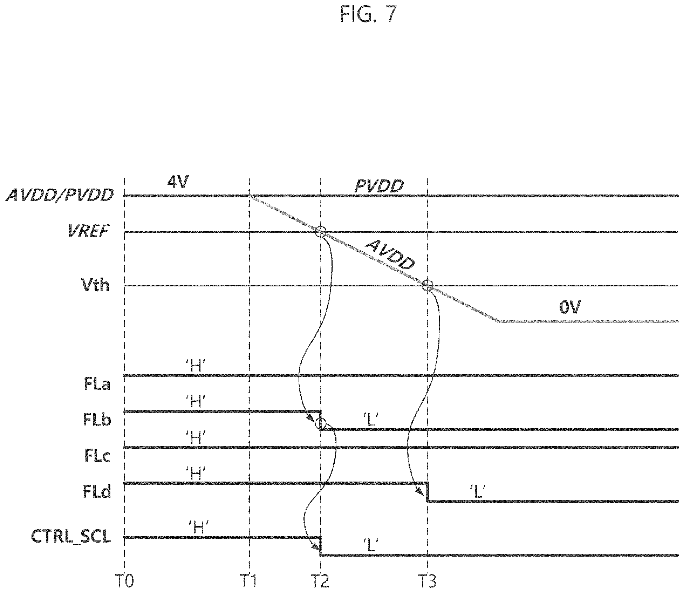

FIG. 7 is a timing diagram illustrating a process of generating a current control signal CTRL_SCL by a power drop sensor during a ground short test the second chip voltage AVDD according to at least one example embodiment of the inventive concepts. Referring to FIGs. 5 and 7, an operation of the power drop sensor 1220 will be described in the case where the first chip voltage PVDD maintains a normal level and the second chip voltage AVDD drops rapidly during the ground short test, but the example embodiments are not limited thereto.

The period between T0 to T1 of FIG. 7 shows an operating state of the power drop sensor 1220 before the ground short test operation is performed. During this period, the chip voltages AVDD and PVDD each maintain a normal level higher than the reference voltage VREF. Accordingly, the inverters INV1 and INV2 and the level detectors 1223 and 1224 all output flag signals FLa, FLb, FLc, and FLd of a high level 'H'. Then, the AND gate 1225 receiving the flag signals FLa, FLb, FLc, and FLd outputs the current control signal CTRL_SCL at a high level 'H'.

At time T1, the ground short test operation for the second chip voltage AVDD starts. The first chip voltage PVDD and the second chip voltage AVDD are provided to separate nodes through the first short circuit protection transistor SPT1 and the second short circuit protection transistor SPT2, but the example embodiments are not limited thereto. Accordingly, the first chip voltage PVDD maintains a steady state, but the second chip voltage AVDD starts to drop due to being grounded. However, until the time T2, both the first chip voltage PVDD and the second chip voltage AVDD are still higher than the reference voltage VREF. Accordingly, all of the flag signals FLa, FLb, FLc, and FLd are maintained at a high level 'H'. Accordingly, the AND gate 1225 will output the current control signal CTRL_SCL of high level 'H'.

At time T2, the voltage level of the second chip voltage AVDD becomes lower than the reference voltage VREF. Then, the second comparator 1222 will transition the comparison result from the low level 'L' to the high level 'H'. Then, the second inverter INV2 will transition the second flag signal FLb from the high level 'H' to the low level 'L'. As the second flag signal FLb among the four flag signals FLa, FLb, FLc, and FLd transitions to the low level 'L', the AND gate 1225 converts the current control signal CTRL_SCL to the low level 'L'. Then, the short current limiter 1240 activates the short circuit current limiting operation in response to the low level 'L' transition of the current control signal CTRL_SCL. When the current control signal CTRL_SCL becomes low level 'L', the transistor M5 of the short current limiter 1240 is turned on, and the short circuit protection transistors SPT1 and SPT2 are driven in the saturation mode. Therefore, the short circuit current flowing through the short circuit protection transistors SPT1 and SPT2 is limited to and/or decreased to the saturation current level.

At time T3, the second chip voltage AVDD becomes lower than the threshold voltage Vth (e.g., level threshold voltage, etc.). Then, the second level detector 1224 monitoring the second chip voltage AVDD will transition the fourth flag signal FLd from the high level 'H' to the low level 'L'. As the two flag signals FLb and FLd among the four flag signals FLa, FLb, FLc, and FLd transition to the low level 'L', the AND gate 1225 generates low level 'L' current control signal CTRL_SCL. Accordingly, the short circuit current limiter 1240 will continue to limit and/or decrease the short circuit current activated at the time point T2.

Generation of the current control signal CTRL_SCL through the aforementioned fourth flag signal FLd makes it possible to compensate for the error of the second comparator 1222 at the time point T2. That is, even when the comparison between the second chip voltage AVDD and the reference voltage VREF is not normally performed due to the failure of the second comparator 1222 at time T2, the current control signal CTRL_SCL may normally transition by the second level detector 1224.

In the above, the operation of the power drop sensor 1220 when the second chip voltage AVDD is grounded in, for example, the ground short test operation has been described, but the example embodiments are not limited thereto. The power drop sensor 1220 may activate the short circuit current limitation through the current control signal CTRL_SCL when any one of the chip voltages AVDD and PVDD is lower than the reference voltage VREF, etc. In addition, even when the second chip voltage AVDD is lowered during the ground short test operation, the power drop sensor 1220 is driven using the internal power supply voltage VDDX managed as a node separated from the second chip voltage AVDD. Therefore, even during the ground short test operation, the function of monitoring the chip voltages AVDD and PVDD of the power drop sensor 1220 and generating the current control signal CTRL_SCL may be increased, improved, and/or guaranteed, etc.

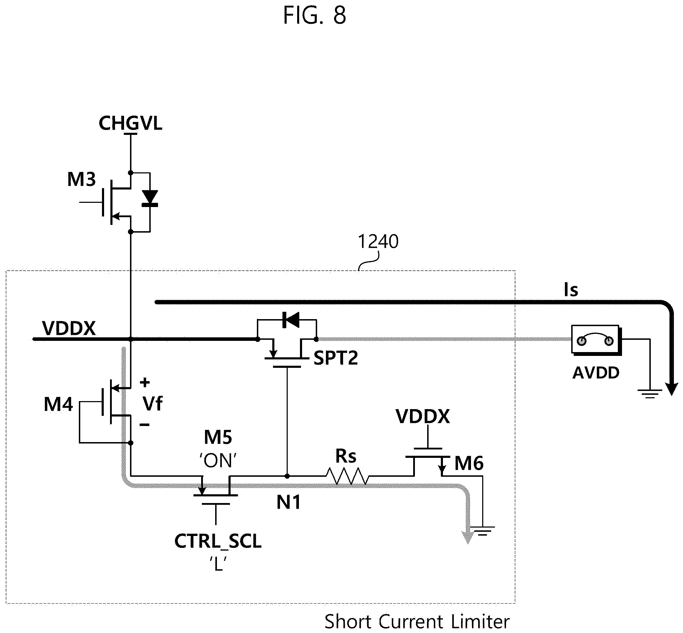

FIG. 8 is a circuit diagram for explaining the short circuit current limiting operation of the short current limiter according to at least one example embodiment of the inventive concepts. Referring to FIG. 8, an operation of the short current limiter 1240 for limiting the short circuit current during a ground short test for the second chip voltage AVDD will be described, but the example embodiments are not limited thereto. Hereinafter, the short circuit current limiting operation will be described focusing on the function of the plurality of gate control circuits, e.g., gate control circuits M4, M5, M6, etc., and resistor Rs that control the gate voltage of the second short circuit protection transistor SPT2, but the example embodiments are not limited thereto. An operation of the short current limiter 1240 during the ground short test operation for the second chip voltage PVDD is substantially the same as in the ground short test operation for the second chip voltage AVDD and thus description thereof is omitted, but the example embodiments are not limited thereto.

During a ground short test operation for the second chip voltage AVDD, an output terminal of the second chip voltage AVDD is grounded on the test board, but is not limited thereto. The voltage level of the second chip voltage AVDD, which is monitored by the power drop sensor 1220, becomes lower than the reference voltage VREF due to the grounding, and the power drop sensor 1220 provides the current control signal CTRL_SCL corresponding to the low level 'L' based the results of the detection of the voltage level drop. Then, the PMOS type transistor M5 is turned on. As transistor M5 is turned on, the internal power supply voltage VDDX node is electrically connected to ground via diode-connected transistors M4, M5, resistor Rs, and transistor M6, but is not limited thereto.

The gate voltage VDDX-Vf of the second short circuit protection transistor SPT2 is formed at the first node N1 by the resistor Rs present on the current path formed between the internal power voltage VDDX node and the ground node, but the example embodiments are not limited thereto. The gate-source voltage Vgs of the second short circuit protection transistor SPT2 is controllable by adjusting the size (e.g., the resistance value) of the resistor Rs. The operation mode of the second short circuit protection transistor SPT2 is changed from a fully turn-on mode to a saturation mode according to and/or based on the turn-on of the transistor M5. Accordingly, the short circuit current 'Is' flowing through the second short circuit protection transistor SPT2 may be limited and/or decreased to a desired saturation current level. In addition, the body diode of the power transistor M3 and the body diode of the second short circuit protection transistor SPT2 are connected in a back-to-back fashion, but the example embodiments are not limited thereto. Therefore, current through the parasitic diode is decreased and/or is not generated during the ground short test.

In the above, the short circuit current limiting function of the short current limiter 1240 during the ground short test has been briefly described. During the ground short test operation, the first short circuit protection transistor SPT1 and/or the second short circuit protection transistor SPT2 is operated in saturation mode by the current control signal CTRL_SCL generated by the power drop sensor 1220, etc. As it operates in the saturation mode, the short circuit current Is flowing through the first short circuit protection transistor SPT1 and/or the second short circuit protection transistor SPT2 is limited and/or decreased to the level of the saturation current of these transistors, etc.

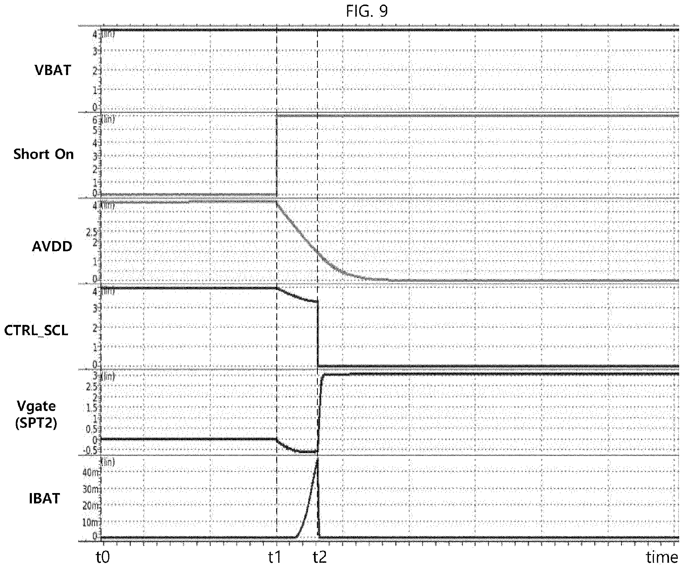

FIG. 9 is an example waveform diagram of a charger integrated circuit according to at least one example embodiment of the inventive concepts. Referring to FIG. 9, it is assumed that the battery voltage VBAT is selected as the power supply voltage supplied as the internal power voltage VDDX, but the example embodiments are not limited thereto.

A period from, e.g., time t0 to time t1, shows an operating state of the power drop sensor 1220 before the ground short test is performed. During this period, the second chip voltage AVDD maintains the same and/or similar voltage level (e.g., within +/- 10%, etc.) to the battery voltage VBAT, but is not limited thereto. Also, the level (e.g., the logic level, etc.) of the current control signal CTRL_SCL provided from the power drop sensor 1220 maintains the high level 'H' (e.g., high logic level, etc.). Therefore, the transistor M5 is turned off, and the voltage of the first node N1 and/or the gate voltage Vgate of the second short circuit protection transistor SPT2 is at the ground level (e.g., approximately 0V, etc.). In this case, the battery current IBAT that supplies the battery voltage VBAT is small enough to be negligible (e.g., approximately 0 mA, etc.), but the example embodiments are not limited thereto.

At the time 11, the ground short test starts (Short On). That is, for example, the second chip voltage AVDD terminal is connected to ground, but the example embodiments are not limited thereto. Then, the voltage level of the second chip voltage AVDD, which is monitored by the power drop sensor 1220, starts to drop rapidly due to the connection to ground. As the voltage level of the second chip voltage AVDD drops, the battery current IBAT starts to increase rapidly. At this time, the battery current IBAT may rapidly increase to 2A or more.

At time t2, the power drop sensor 1220 transitions the current control signal CTRL_SCL to a low level 'L' (e.g., low logic level) based on the detection of the voltage level drop of the second chip voltage AVDD, but is not limited thereto. Then, the transistor M5 receiving the current control signal CTRL_SCL as a gate voltage is turned on. When the transistor M5 is turned on, the voltage of the first node N1 and/or the gate voltage Vgate of the second short circuit protection transistor SPT2 transitions to a high level 'H'. As the gate voltage Vgate transitions to the high level 'H', the second short circuit protection transistor SPT2 operates in a saturation mode, etc. Then, the short circuit current flowing through the second short circuit protection transistor SPT2 is limited and/or decreased to the saturation current level, etc. According to the limitation of the short circuit current flowing through the second short circuit protection transistor SPT2, the battery current IBAT flowing through the battery may return to a normal state (e.g., 0 mA), but the example embodiments are not limited thereto.

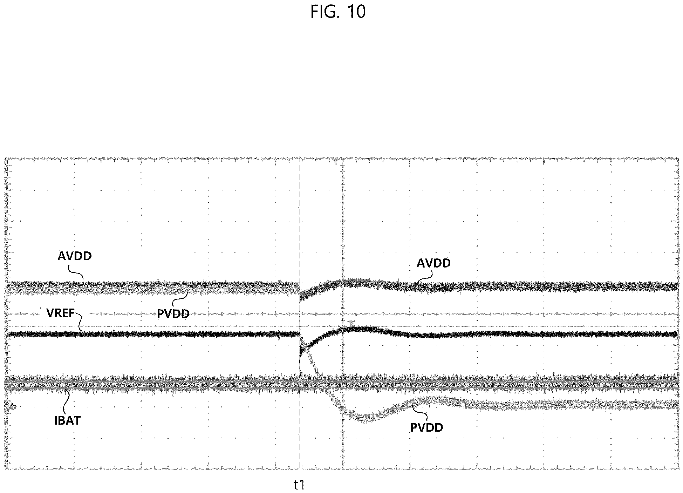

FIG. 10 is a graph showing a result of a ground short test for a first chip voltage PVDD of a charger integrated circuit according to at least one example embodiment of the inventive concepts. Referring to FIG. 10, it may be confirmed that the battery current IBAT may be stably limited and/or decreased even if the level of the first chip voltage PVDD drops rapidly due to a short circuit, etc., but the example embodiments are not limited thereto.

At time t1, the ground short test (e.g., ground short test operation, short circuit test operation, etc.) for the first chip voltage PVDD starts. The first chip voltage PVDD and/or the second chip voltage AVDD are provided to separated nodes through the first short circuit protection transistor SPT1 and the second short circuit protection transistor SPT2, but the example embodiments are not limited thereto. Accordingly, even when the first chip voltage PVDD is grounded, the second chip voltage AVDD may maintain a normal state, but the example embodiments are not limited thereto.

However, the first chip voltage PVDD, which is monitored by the power drop sensor 1220, becomes lower than the reference voltage VREF (e.g., desired voltage, etc.) at time 11. In response to this, the power drop sensor 1220 outputs the current control signal CTRL_SCL at a low level 'L'. Then, the transistor M5 of the short current limiter is turned on, and the first short circuit protection transistor SPT1 operates in a saturation mode. According to the saturation mode operation of the first short circuit protection transistor SPT1, the short circuit current is limited and/or decreased, and the battery current IBAT of the battery supplying the battery voltage VBAT may be restored (e.g., returned to a normal level of current, a desired level of current, etc.). The change and/or recovery of the battery current IBAT shown may be so minor that it is hidden in the ripples, etc.

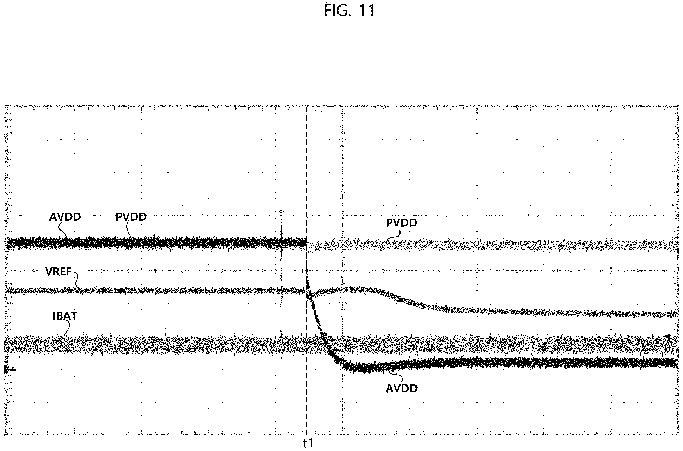

FIG. 11 is a graph showing a result of a ground short test for the second chip voltage AVDD of the charger integrated circuit according to at least one example embodiment of the inventive concepts. Referring to FIG. 11, it may be confirmed that the battery current IBAT may be stably limited and/or decreased even when the level of the second chip voltage AVDD decreases and/or rapidly decreases.

At time t1, the ground short test operation for the second chip voltage AVDD starts. The first chip voltage PVDD and/or the second chip voltage AVDD are provided to separate nodes through the first short circuit protection transistor SPT1 and/or the second short circuit protection transistor SPT2, etc. Accordingly, even when the second chip voltage AVDD is grounded, the first chip voltage PVDD may maintain a normal state, but the example embodiments are not limited thereto.

However, the second chip voltage AVDD, which is monitored by the power drop sensor 1220, becomes lower than the reference voltage VREF (e.g., the desired voltage level, a reference threshold voltage level, etc.) at time t1. In response to this, the power drop sensor 1220 outputs the current control signal CTRL_SCL at a low level 'L'. Then, the transistor M5 of the short current limiter is turned on, and the second short circuit protection transistor SPT2 operates in a saturation mode. According to the saturation mode operation of the second short circuit protection transistor SPT2, the short circuit current is limited and/or decreased, and the battery current IBAT of the battery supplying the battery voltage VBAT may be restored (e.g., returned to a normal level, returned to a desired level, etc.). The change and/or recovery of the battery current IBAT shown may be so minor that it is hidden in the ripples, but the example embodiments are not limited thereto.

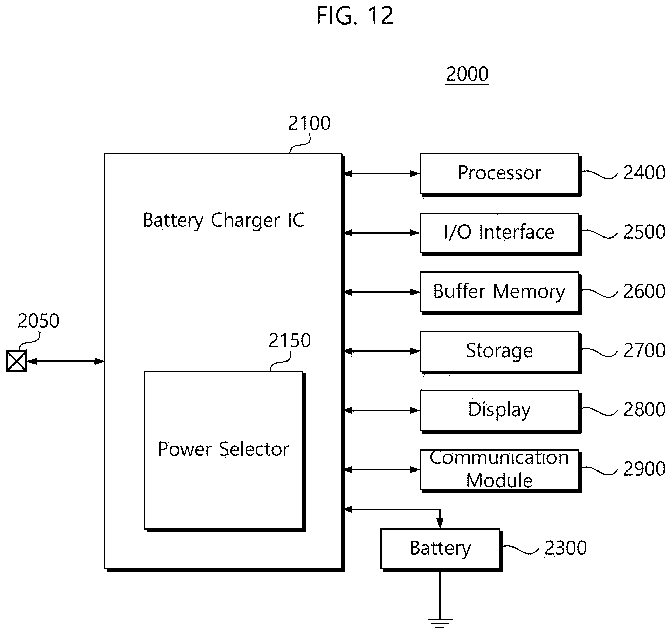

FIG. 12 is a block diagram showing a power system of a mobile device according to at least one example embodiment of the inventive concepts. Referring to FIG. 12, a power system 2000 may include a battery charging IC 2100 and/or a battery 2300, etc., but is not limited thereto, and for example, may include a greater or lesser number of constituent components.

The battery charger IC 2100 includes the power selector 2150 of at least one example embodiment of the inventive concepts. The power selector 2150 may limit a short circuit current generated during a ground short test operation for the first chip voltage PVDD and/or the second chip voltage AVDD, but is not limited thereto, and for example, the power selector 2150 may further limit a short circuit current generated during normal operation of the battery charger IC 2100 and/or the power system 2000, etc. Through the short circuit current limiting function, the power selector 2150 may protect internal elements and/or components of the mobile device from impact and/or damage due to overcurrent, etc. In addition, the power selector 2150 may continuously supply an internal power supply voltage (not shown, VDDX) capable of driving internal circuits even when the first chip voltage PVDD and/or the second chip voltage AVDD are grounded. Therefore, even if the ground short test is performed for the first chip voltage PVDD and/or the second chip voltage AVDD, the power selector 2150, power system 2000, and the mobile device may normally perform internal functions and/or operations, etc. Configuration and operations of the battery charger IC 2100 according to at least one example embodiment of the inventive concepts may operate as described in FIGs. 1 to 11, but is not limited thereto.

The battery charger IC 2100 may provide a stable voltage to other components of the mobile electronic device. For example, each of at least one processor 2400, an input/output interface 2500, a buffer memory 2600, a storage 2700, a display 2800, and/or a communication module 2900 (e.g., communication interface, communication radio, etc.), etc., included in a mobile electronic device may operate using the stable voltage provided from the power management IC 2200. According to some example embodiments, the charger IC 2100, the at least one processor 2400, the input/output interface 2500, the buffer memory 2600, the storage 2700, and/or the communication module 2900, etc., may be implemented as processing circuitry. The processing circuitry may include hardware or hardware circuit including logic circuits; a hardware/software combination such as a processor executing software and/or firmware; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc., but is not limited thereto.

As an example, the battery charger IC 2100 may be implemented as an integrated circuit chip and/or as circuitry, etc. The battery charger IC 2100 may be mounted using various types of semiconductor packages. For example, the battery charger IC 2100 may be mounted using at least one of Package on Package (PoP), Ball Grid Arrays (BGAs), Chip Scale Packages (CSPs), Plastic Leaded Chip Carrier (PLCC), Plastic Dual In-line Package (PDIP), Die in Waffle Pack, Die in Wafer Form, COB (Chip On Board), CERDIP (Ceramic Dual In-line Package), MQFP (Metric Quad Flat Pack), TQFP (Thin Quad Flat Pack), SOIC (Small Outline Integrated Circuit), SSOP (Shrink Small Outline Package), TSOP (Thin Small Outline Package), SIP (System In Package), MCP (Multi Chip Package), WFP (Wafer-level Fabricated Package), WSP (Wafer-Level Processed Stack Package), etc., but is not limited thereto.

Various example embodiments for carrying out the inventive concepts are disclosed in detail above. In addition to the above-described example embodiments, the inventive concepts may include simple design changes or easily changeable aspects of the example embodiments. In addition, the inventive concepts will include techniques that may be easily modified and implemented using the example embodiments. Therefore, the scope of the inventive concepts should not be limited to the above-described example embodiments.

## Claims

1. A charger integrated circuit, comprising:
a plurality of power transistors configured to,
receive a battery voltage, a charging voltage, and a load voltage, respectively, and transmit one of the battery voltage, the charging voltage, and the load voltage to a first power node as an internal power supply voltage based on a voltage selection control signal;
a voltage selector configured to,
determine a highest voltage among a battery voltage, a charging voltage, and a load voltage, and
transmit the voltage selection control signal to the plurality of power transistors based on results of the determination;
a short current limiter configured to,
output the internal power supply voltage as a chip voltage, and
limit a level of a short circuit current corresponding to the chip voltage flowing to ground in response to a current control signal; and
a power drop sensor configured to generate the current control signal in response to a voltage level of the chip voltage being lower than a voltage level of a reference voltage.

2. The integrated circuit of claim 1, wherein the power drop sensor is further configured to:
use the internal power supply voltage as a power source; and
monitor the chip voltage to determine whether the voltage level of the chip voltage is lower than the voltage level of the reference voltage.

3. The integrated circuit of claim 2, wherein the power drop sensor comprises:
a comparator configured to compare the voltage level of the chip voltage with the voltage level of the reference voltage;
an inverter configured to generate a first flag signal by inverting the comparison result;
a level detector configured to generating a second flag signal in response to the chip voltage being lower than a level threshold voltage, a voltage level of the level threshold voltage being lower than a voltage level of the reference voltage; and
an AND gate configured to generate the current control signal by performing a logical AND operation on at least the first flag signal and the second flag signal.

4. The integrated circuit of claim 3, wherein the comparator, the inverter, and the AND gate are each configured to use the internal power supply voltage as a power source.

5. The integrated circuit of any one of the preceding claims, wherein the short current limiter includes:
a short circuit protection transistor configured to provide the internal power supply voltage formed at the first power node as the chip voltage.

6. The integrated circuit of claim 5, wherein the short current limiter comprises:
a first transistor including a source connected to the first power node;
a second transistor including a source connected to a drain and a gate of the first transistor, the second transistor configured to provide a gate voltage to a gate of the short circuit protection transistor in response to the current control signal; and
a resistor connected between the gate of the short circuit protection transistor and a ground node, the resistor configured to set a voltage level of the gate voltage.

7. The integrated circuit of claim 6, wherein the short circuit protection transistor is configured to operate in a saturation mode in response to the second transistor being turned on.

8. The integrated circuit of any one of the preceding claims, wherein the chip voltage includes:
a first chip voltage used as an analog power supply of the charger integrated circuit; and
a second chip voltage used to perform at least one internal logic operation.

9. A charger integrated circuit, comprising:
a first power transistor configured to switch a power supply voltage to a first power node;
a second power transistor configured to switch the power supply voltage to a second power node to provide a first chip voltage;
a power drop sensor configured to activate a current control signal in response to a voltage level of the first chip voltage being lower than a voltage level of a reference voltage; and
a gate control circuit configured to switch the second power transistor from a turned-on mode to a saturation mode in response to activation of the current control signal, the saturation mode causing a current of the first chip voltage to be limited to a desired current level.

10. The charger integrated circuit of claim 9, wherein
the first power transistor includes a first body diode;
the second power transistor includes a second body diode; and
a drain of the first power transistor is connected to a drain of the second power transistor such that the first and second body diodes are connected in a back-to-back form.

11. The charger integrated circuit of claim 9 or 10, wherein the gate control circuit comprises:
a first transistor including a source connected to the first power node;
a second transistor including a source connected to a drain and a gate of the first transistor, and the second transistor is configured to provide a gate voltage to a gate of the second power transistor in response to the current control signal; and
a resistor coupled between the gate of the second power transistor and a ground node.

12. The charger integrated circuit of claim 11, wherein the gate control circuit includes:
a third transistor configured to switch between the second transistor and a ground node in response to a voltage level of the power supply voltage.

13. A ground short test method of a charger integrated circuit comprising:
transferring a selected power supply voltage to a first power node through a power transistor;
comparing a voltage level of a chip voltage with a voltage level of a reference voltage, the chip voltage being output from a second power node; and
operating a short circuit protection transistor to limit a current of the chip voltage in response to the voltage level of the chip voltage being lower than the voltage level of the reference voltage, the short circuit protection circuit connected to the first power node and the second power node.

14. The method of claim 13, wherein
the power transistor includes a first body diode;
the short circuit protection transistor includes a second body diode; and
the first and second body diodes are connected in a back-to-back form.

15. The method of claim 13 or 14, further comprising:
in response to the voltage level of the chip voltage being equal to or greater than the voltage level of the reference voltage, driving the short circuit protection transistor in a turned-on mode.
